(19) Europäisches Patentamt
European Patent Office
Office européen des brevets

(11) Publication number: **0 403 100 A2**

(12) **EUROPEAN PATENT APPLICATION**

(21) Application number: **90305787.5**

(51) Int. Cl.$^5$: **G03F 7/029**

(22) Date of filing: **29.05.90**

(30) Priority: **30.05.89 US 357909**

(43) Date of publication of application:
**19.12.90 Bulletin 90/51**

(84) Designated Contracting States:
**CH DE FR GB IT LI**

(71) Applicant: **MINNESOTA MINING AND MANUFACTURING COMPANY**
**3M Center, P.O. Box 33427**
**St. Paul Minnesota 55133(US)**

(72) Inventor: **Ali, Mohammad Zaki, c/o Minnesota Mining and**
**Manufacturing Company, 2501 Hudson Road**
**St. Paul, Minnesota 55144-1000(US)**

(74) Representative: **Baillie, Iain Cameron et al**
**c/o Ladas & Parry Isartorplatz 5**
**D-8000 München 2(DE)**

(54) **High sensitivity photopolymerizable compositions containing hydrogen donating mercaptans.**

(57) The invention provides sensitivity increases in high light sensitivity free radical photopolymerization reactions. Compositions based on ethylenically unsaturated monomers or oligomers and photoinitiators selected from iodonium salts and halotriazines show higher speeds by the addition of hydrogen donating mercapto compounds. The compositions are valuable in negative-acting photopolymerizable compositions such as high speed printing plates.

EP 0 403 100 A2

# HIGH SENSITIVITY PHOTOPOLYMERIZABLE COMPOSITIONS CONTAINING HYDROGEN DONATING MERCAPTANS

## CROSS-REFERENCE TO RELATED CASES

U.S. Patent Application Serial Number 272,520, filed on November 17, 1988, bearing Attorney's Docket No. FN 43199USA4A discloses a ternary photoinitiator system containing trihalo-s-triazines iodonium salts which produces high speed photopolymerizable composition.

U.S. Patent Application Serial Number 275,515, filed on November 23, 1988, bearing Attorney's Docket No. FN 43024USA3A discloses constrained alkylamino ketone sensitizers for iodonium salts (and triazines) to produce high speed photopolymerizable systems.

U.S. Patent Application Serial Number 275,516, filed on November 23, 1988, bearing Attorney's Docket No. FN 43025USA1A discloses photopolymerizable compositions containing an initiator chosen from iodonium salts and halogenated triazines, and a spectral sensitizer of the constrained alkylamino ketone class.

## BACKGROUND OF THE INVENTION

### Field of Invention

This invention relates to free radical polymerizable compositions containing a photoinitiator. More particularly it relates to polymerizable compositions comprising ethylenically unsaturated monomers or oligomers containing sensitized iodonium salts or triazines.

### Information Disclosure Statement

High speed photopolymerizable systems are very desirable for applications such as projection exposure imaging and imaging by laser scanning techniques. For these applications and particularly for laser scanning applications, high speed is essential to keep the exposure time short and also to be able to use lower intensity light sources or lower powered lasers, which are cheaper and more reliable than higher intensity light sources. For these reasons various efforts are being carried out to improve the sensitivity of photopolymerizable compositions. Some of the representative patents which disclose high speed photopolymerizable compositions are U.S. Patents 4,594,310 (Mitsubishi Chem. Ind. KK); 4,259,432 (Fuji Photo Film); 4,162,162; 3,871,885; 4,555,473 (DuPont); 4,147,552 (Eastman Kodak) and European Patent 109,291 (Fuji Photo Film) and 196,561 (Nippon Oils and Fats) and BE 897,694 (Nippon Oils and Fats).

Although some of these photopolymerizable compositions exhibit high sensitivity (<1.0 mj/cm$^2$) in the UV, most of them have lower (>2.0 mj/cm$^2$) sensitivity at visible wavelengths (such as the 488 nm argon ion laser line). U.S. Patent 4,228,232 (3M) describes a photopolymerizable composition with photosensitivity of <2.0 mj/cm$^2$ at 488 nm. This composition utilizes a sensitized iodonium salt photoinitiator system. Sensitized iodonium salt photoinitiator systems are also described in U.S. Patents 3,729,313 (3M), and 4,250,053 (3M).

While the aforementioned compositions have provided improved photospeed, there is still need for more sensitive photopolymer compositions. Higher photospeed allows utilization of low cost exposure devices (such as low intensity argon ion lasers) for applications such as projection exposure imaging and imaging by laser scanning techniques.

U.S. Patent 3,479,185 (DuPont) describes sensitized biimidazole initiator systems and describes sensitivity improvement by the incorporation of organic thiol chain transfer agents. Sensitivity improvement by chain transfer agents of sensitized biimidazole systems are also described by W. I. Chambers and D. F. Eaton in the Journal of Imaging Science, Vol. 30, No. 5, 1986. They observed that mercaptobenzthiazole increased the photospeed by a factor of 2 or more.

U.S.Patent 4,629,679 (Mitsubishi Rayon) discloses photopolymerizable compositions containing an initiator and a mono- or di-mercapto tetrazole to improve adhesion to metal surfaces.

U.S.Patent 4,657,942 (Fuji Photo Film) discloses compositions containing a polyfunctional monomer, a photopolymerization initiator, and a 2-mercapto-5-substituted thiadiazole, which provides good photosensitivity. No other hydrogen donor thio compounds, such as mercaptobenzazoles, are disclosed. The five classes of photoinitiators disclosed as useful include halogenized triazines but do not include diaryliodonium salts. No explicit examples or speed increase figures are given for triazines. There is a specific requirement in both disclosure and claims that there be present at least one polyfunctional monomer with at least two ethylenically unsaturated bonds in the molecule.

## SUMMARY OF THE INVENTION

It has been found that the speed of high sensitivity photopolymerizable compositions containing sensitized diaryliodonium salts or sensitized halotriazines can be further increased by the incorporation of mercapto hydrogen donor compounds.

An aspect of the invention is to provide a high sensitivity photopolymerization initiator or initiator system for use in a photopolymerizable compositions which is a so-called light-sensitive resin (photoresist) composition.

Another aspect of the invention is to provide a photopolymerization initiator or initiator system which is used to increase the rate of photopolymerization of a photopolymerizable composition containing an ethylenically unsaturated compound.

The present invention, therefore, relates to photopolymerizable compositions comprising a polymerizable compound containing at least one ethylenically unsaturated double bond (this includes both monomers and oligomers), and a photopolymerization initiator composition comprising (A) a spectrally sensitized diaryliodonium salt, or a halogenated alkyltriazine together with a spectral sensitizer and an electron donor compound, and (B) a hydrogen donating mercapto compound selected from mercaptothiadiazoles and mercaptobenzazoles. Alternatively the initiator composition can comprise a spectrally sensitized halogenated alkyltriazine and a mercaptobenzazole.

Speed improvement by hydrogen donor thio compounds when used in combination with biimidazole, halogenated hydrocarbons, and halogenated triazines has been disclosed. None of the prior art teaches the use of the hydrogen donor thio compounds to increase the speed of polymerization in the presence of diaryliodonium salt photoinitiation systems. It is surprising to find that, in the present invention already highly efficient spectrally sensitized diaryliodonium salt photoinitiators can be further improved by the incorporation of the hydrogen donor thio compounds. It is also surprising to find that the photospeed of highly efficient spectrally sensitized ternary photoinitiation systems wherein the third component is an electron donor compound (U.S. Patent Applications Serial Numbers 34,065 filed April 2, 1987, and 272,520 filed November 17, 1988) can be further improved by the addition of hydrogen donor thio compounds.

## DETAILED DESCRIPTION OF THE INVENTION

Aromatic iodonium salts whose photoinitiation can be enhanced in accordance with this invention are disclosed in U.S. Patent 4,250,053 and are selected from those having the general formulae

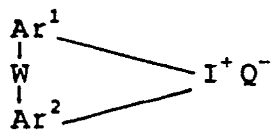

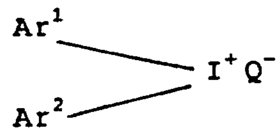

wherein,

$Ar^1$ and $Ar^2$ are aromatic groups having from 4 to 20 carbon atoms and are preferably selected from phenyl, naphthyl, thienyl, furanyl and pyrazolyl groups,

W is selected from

a single bond,

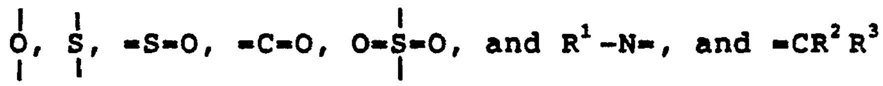

where $R^1$ is aryl of 6 to 20 carbon atoms, acyl of 2 to 20 carbon atoms, and where $R^2$ and $R^3$ are selected from hydrogen,alkyl groups of 1 to 4 carbon atoms,
Q is any anion, preferably an acid anion, and more preferably a halogen-containing complex anion selected from tetraborate, hexafluorophosphate, hexafluoroarsenate, and hexafluoroantimonate.

Halogenated triazines which can be used as photoinitiators in this invention are disclosed in U.S. Patent 3,617,288. Halogenated triazine compounds substituted by at least one trihalomethyl group are disclosed for example in U.S. 4,505,793 and are represented by the general formula:

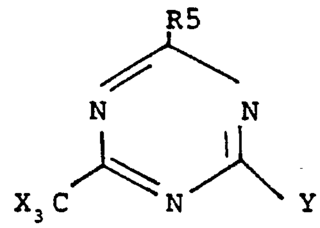

wherein,
X is a halogen atom (preferably chlorine or bromine),
Y is $-CX_3$, $-NH_2$, $-NHR^4$, $-NP^4{}_2$, or $-OR^4$, wherein $R^4$ is an alkyl group of 1 to 4 carbon atoms or an aryl group containing 6 to 10 carbon atoms, and
$R^5$ is $-CX_3$, an alkyl group of 1 to 12 carbon atoms, an aryl group of 6 to 12 carbon atoms, an alkenyl group of 2 to 12 carbon atoms, or an aralkenyl group containing from 8 to 20 carbon atoms.

Preferred initiators are diphenyliodonium hexafluorophosphate and diphenyliodonium chloride.

Sensitizers for iodonium salts are described in U.S. Patents 3,729,313, 4,250,053 and U.S. Patent Application Serial Number 275,516, filed November 23, 1988. Preferred sensitizers are constrained amino ketone sensitizers.

A wide range of spectral sensitizers for halogenated hydrocarbon and halogenated triazine photoinitiators has been disclosed in the art. U.S. Patent 3,617,288 describes spectral sensitizers for halogenated hydrocarbon compounds. U.S. Patent 4,505,793 describes ketocoumarin sensitizers for halogenated triazines for free radical polymerization U.S. Patent 4,505,793 discloses constrained coumarin sensitizers for triazine initiators. Ketones (e.g., monoketones or alpha-diketones), ketocoumarins, aminoarylketones, p-substituted aminostyryl ketone compounds, merocyanines, and aromatic polycyclic hydrocarbons are preferred sensitizers for triazines in this invention.

Electron donor compounds which may be used with the halogenated triazines in one embodiment of this invention are disclosed in copending U.S. Patent Application Serial Number 272,520, filed November 17, 1988, and are selected from

a) compounds wherein the donor atoms are situated in a charged group,

and

b) compounds wherein the donor atoms are situated in a neutral group and wherein there is an abstractable hydrogen atom bonded to a carbon or silicon atom alpha to the donor atom, said donor atoms being selected from nitrogen, oxygen, phosphorus, and sulfur, said electron donor compound being different from said spectral sensitizer and being chosen such that
zero $< E_{ox}$ (donor) $< E_{ox}$ (p-dimethoxybenzene).

The hydrogen donating mercapto compounds have a structure selected from those represented by general formulae 1 and 2

1) 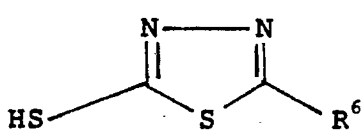

2) 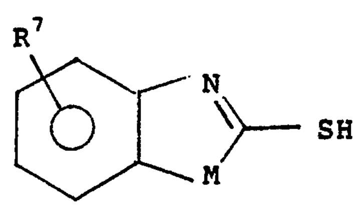

wherein $R^6$ is -SH, an alkyl group, an aralkyl group, an alkylthioether group, or an aralkyl-thioether group, $R^7$ is alkyl, alkoxy, hydroxy, or a halogen, and, M is oxygen, sulfur, or $=NR^8$ where $R^8$ is H or lower alkyl. Alkyl groups $R^6$ and $R^7$ preferably have fewer than twelve carbon atoms and aromatic groups preferably have fewer than 20 carbon atoms.

Representative hydrogen atom donor thio compounds are 2 mercaptobenzothiazole,
2-mercaptobenzoxazole,
2-mercaptobenzimidazole,
pentaerythritol tetrakis (mercaptoacetate),
4-acetamidothiophenol,
mercaptosuccinic acid,
dodecanethiol,
beta-mercaptoethanol,
2-mercapto-5-methylthio-1,3,4-thiadiazole,
2-mercapto-5-methyl-1,3,4-thiadiazole,
2-mercapto-5-benzylthio-1,3,4-thiadiazole,
2-mercapto-5-n-hexylthio-1,3,4-thiadiazole,
2,5-dimercapto-1,3,4-thiadiazole.

The preferred thio compounds are 2-mercaptobenzthiazole, 2-mercaptobenzoxazole, 2-mercapto-5-alkyl-1,3,4-thiadiazole, and 2,5-dimercapto-1,3,4-thiadiazole.

In the embodiment using a halogenated alkyltriazine with a spectral sensitizer but without an electron donor compound, the hydrogen donating mercapto compound is selected from those of structure 2 above.

The free radically polymerizable compound used herein is a compound containing at least one ethylenically unsaturated double bond and this may be a monomer, a prepolymer, i.e. a dimer a trimer and other oligomers, a mixture thereof, or a copolymer. Suitable examples and preferred monomers are listed in U.S. Patent 4,228,232. Suitable examples and preferred oligomers are disclosed in U.S. Patent 4,476,215.

The photopolymerizable composition of the invention containing the above-described ethylenic compound and photosensitizer-initiator system may further contain, if desired, known additives such as a binder, a thermal polymerization inhibitor, a plasticizer, a coloring agent and a surface lubricant (e.g., U.S. Patent 4,228,232).

The polymerizable compositions of the present invention are particularly useful in presensitized printing plate, and color proofing systems. The high speed of the compositions along with their good storage stability are very desirable for commercialization of projection exposure imaging systems, particularly for exposure by laser scanning techniques.

## EXAMPLES

To test the effectiveness of the hydrogen atom donor mercapto compounds with iodonium compounds (and halogenated triazines) in a photopolymerizable element, the following stock solution was prepared:

| | | |
|---|---|---|
| 1. | Azeotrope (72% n-propanol, 28% water w/w) | 27.6 g |
| 2. | Pentaerythritol tetraacrylate SR-295 (from Sartomer Co.) | 1.0 g |
| 3. | U-34 oligomer (61% in MEK) (IV, in U.S. 4,228,232) | 1.4 g |
| 4. | Triethylamine | 0.07 g |
| 5. | Hydroxypropylcellulose, Klucell M (1.5% in azeotrope) (from Hercules) | 12.3 g |
| 6. | Millbase (Sunfast blue and Formvar 12/85 1:2; 13.7% solids in azeotrope) | 2.0 g |

### Examples 1-8

To 5g of the above formulation was added 2-6mg of sensitizer, 20 mg of $Ph_2I^+PF_6^-$, and 2-5mg of other additives as shown in the table. The solution was then coated with wire wound rods onto grained and anodized aluminum at coating weights of 100-200 mg/ft$^2$ and dried at 150° F for 2 min. The plate was then top coated with 5% aqueous polyvinyl alcohol, in some examples containing 0.25% of $Ph_2I^+PF_6^-$ , with a

small amount of inert surfactant (Triton X-100, 0.03%) as a coating aid, at a coating weight of 100-200 mg/ft$^2$. In one sample the polyvinyl alcohol substituted with an equal weight mixture of polyvinylalcohol and carboxymethylcellulose. The dried samples were exposed through a $\sqrt{2}$ density increment, 21 step Stouffer sensitivity guide for 2 sec. with a 16,000 foot candle tungsten light source at 10 inches (3M Model 70 light source). The exposed plates were developed with an aqueous solution of 4% n-propanol, 2% sodium metasilicate and 0.06% Dowfax$^R$ 2A1 surfactant (Dow Chemical Company). Table I shows the polymer retained according to the number of steps after exposure and development. The step values (solid) indicate the exposure level at which the developed image density can no longer be differentiated from the background and is believed to be cured to the desired level. Absolute sensitivity of some of the samples were also measured by exposing with an argon-ion laser (488 nm) or by exposing at the corresponding absorption maximum of the sensitizer with a one KW high-pressure mercury-xenon light source directed through a monochromator with a 20 nm band pass. The lamp output was measured by a radiometer. For accelerated aging tests, the coated plates were covered with black paper and were kept in an oven set at 140° F (60° C) for three days. After cooling to room temperature the samples were exposed and developed as previously described.

Examples 9-12

Using similar conditions to those for Examples 1-8, tris-trichloromethyl-s-triazine was sustituted for the $Ph_2I^+PF_6^-$. The results of these examples are shown in Table II. Accelerated aging tests were not carried out.

TABLE I

| | Sensitizer | Stabilizer | HDM | Complexing Agent | OBL | Steps Fresh | Steps Incub | |
|---|---|---|---|---|---|---|---|---|
| 1. | A 3mg | - | - | - | PVOH | 11$^+$ | 9 | |
| 2. | A 3mg | - | E 2mg | - | PVOH | 13 | 8 | |
| 3. | B 5mg | - | - | - | PVOH | 11 | 8 | |
| 4. | B 5mg | D 4mg | E 2mg | - | PVOH + Init | 13$^+$ | 10 | |
| 5. | C 4mg | D 4mg | - | EDTA 2mg | PVOH + Init | 16 | 14 | |
| 6. | C 4mg | D 4mg | E 2mg | EDTA 2mg | PVOH + Init | 17$^d$ | 13 | |
| 7. | C 4mg | D 4mg | E 2mg | EDTA 2mg | PVOH + CMC 1:1 | 17 | 14 | |
| 8. | C 4mg | D 4mg | F 2mg | EDTA | PVOH + Init | 18 | | - |

Note: Stabilizer D can act as an electron doner.
HDM = hydrogen donor molecule;
EDTA = ethylenediamine tetraacetic acid. sodium salt;
OBL = oxygen barrier layer;
PVOH = polyvinyl alcohol;
CMC = carboxymethyl cellulose;
d = sensitivity of 600-800 ergs/cm$^2$ at 488 nm.
Init = $Ph_2I^+PF_6^-$
Incub = accelerated aging for 3 days at 140° F

Table II

| | Sensitizer | Electron Donor | HDM | OBL | Steps Fresh |
|---|---|---|---|---|---|
| 9. | G 3mg | none | none | PVOH | 10 |
| 10. | G 3mg | H 4mg | none | PVOH | 12 |
| 11. | G 3mg | H 4mg | E 8mg | PVOH | 13 |
| 12. | G 3mg | none | E 8mg | PVOH | 11 |

## Key to Compounds

A

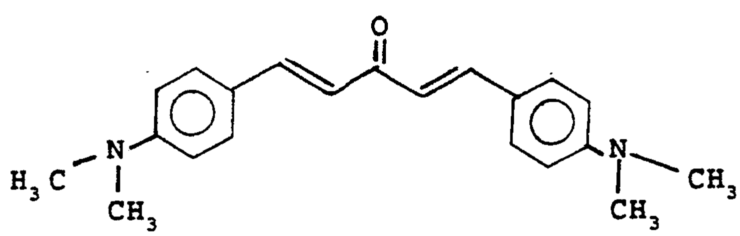

B

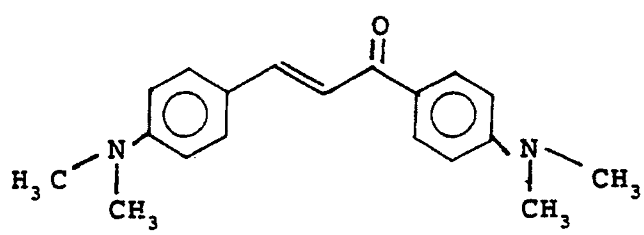

C

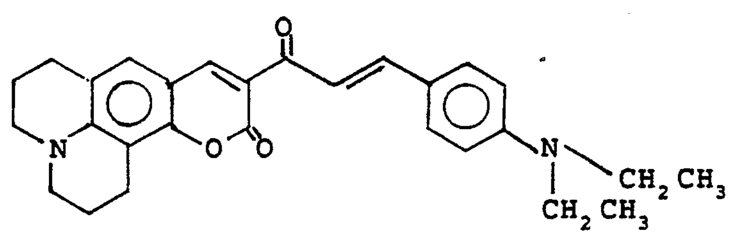

D

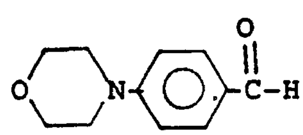

E

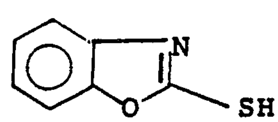

F

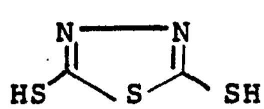

G

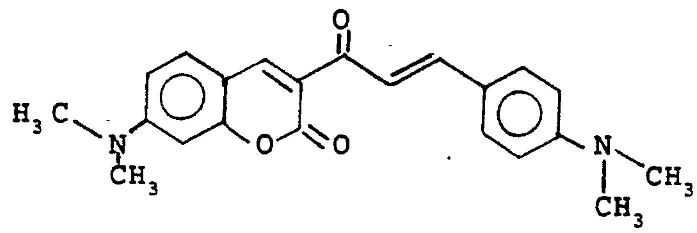

H

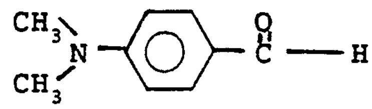

## Claims

1. A high sensitivity photopolymerizable composition comprising

a) at least one free radically polymerizable monomer having at least one ethylenically unsaturated group,

b) an ethylenically unsaturated free radically polymerizable oligomer having carboxyl groups substituted thereon,

c) a photosensitive initiator system for free radical polymerization selected from the group consisting of a) diaryl iodonium salts and b) a combination of halogenated triazine and electron donor compound,

d) a spectral sensitizer having an oxidation potential in the range 0.5 eV to 2.0 eV, and

e) at least one hydrogen donating mercapto compound selected from mercaptothiadiazoles and mercapto-benzazoles.

2. A photopolymerizable composition as recited in claim 1 wherein said diaryl iodonium salts have the general structure

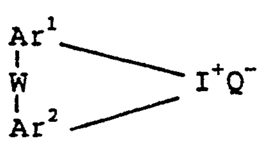

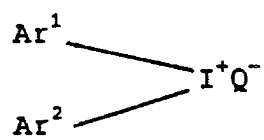

wherein,
$Ar^1$ and $Ar^2$ are aromatic groups having from 4 to 20 carbon atoms and are preferably selected from phenyl, naphthyl, thienyl, furanyl and pyrazolyl groups,
W is selected from
a single bond,

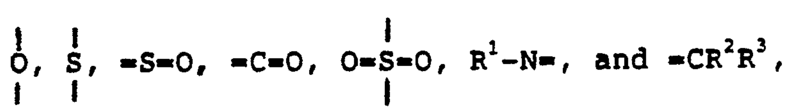

where $R^1$ is aryl of 6 to 20 carbon atoms, acyl of 2 to 20 carbon atoms, are where $R^2$ and $R^3$ are selected from hydrogen, alkyl groups of 1 to 4 carbon atoms,
Q is an anion.

3. A photopolymerizable composition as recited in claim 1 wherein said halogenated triazine has the general structure

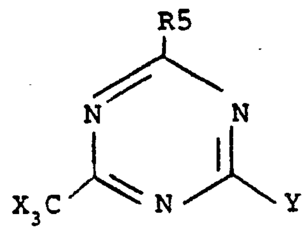

wherein,

X is chlorine or bromine,

Y is $-CX_3$, $-NH_2$, $-NHR^4$, $-NP^4_2$, or $-OR^4$, wherein $R^4$ is an alkyl group of 1 to 4 carbon atoms or an aryl group containing 6 to 10 carbon atoms, and

$R^5$ is $-CX_3$, an alkyl group of 1 to 12 carbon atoms, an aryl group of 6 to 12 carbon atoms, an alkenyl group of 2 to 12 carbon atoms, or an aralkenyl group containing from 8 to 20 carbon atoms,

and said electron donor compound is selected from

a) compounds wherein the donor atoms are situated in a charged group,

and b) compounds wherein the donor atoms are situated in a neutral group and wherein there is an abstractable hydrogen atom bonded to a carbon or silicon atom alpha to the donor atom, said donor atoms being selected from nitrogen, oxygen, phosphorus, and sulfur, said electron donor compound being different from said spectral sensitizer and being chosen such that

zero $< E_{ox}$ (donor) $< E_{ox}$ (p-dimethoxybenzene).

4. A photopolymerizable composition as recited in claim 1 wherein said sensitizer is characterized as conferring sensitivity to visible light.

5. A photopolymerizable composition as recited in claim 1 wherein said hydrogen donating mercapto compounds are selected from those having the general structures

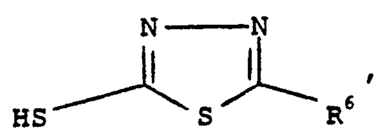 , and 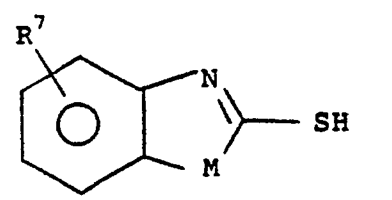 ,

wherein $R^6$ is -SH, an alkyl group, an aralkyl group, an alkylthioether group, or an aralkyl-thioether group,

$R^7$ is alkyl, alkoxy, hydroxy, or a halogen, and

M is oxygen, sulfur, or $=NR^8$ where $R^8$ is H or lower alkyl.

6. A high sensitivity photopolymerizable composition comprising

a) at least one free radically polymerizable monomer having at least one ethylenically unsaturated group,

b) an ethylenically unsaturated free radically polymerizable oligomer having carboxyl groups substituted thereon,

c) a photosensitive initiator system for free radical polymerization comprising halogenated triazines,

d) a spectral sensitizer having an oxydation potential in the range 0.5 eV to 2.0 eV, and

e) at least one hydrogen donating mercapto compound comprising mercaptobenzazoles.

7. A photopolymerizable composition as recited in claim 6 wherein said halogenated triazines have the general structure

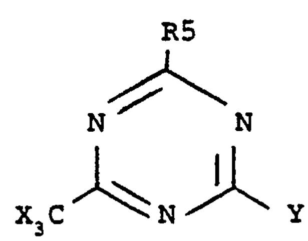

wherein,

X is chlorine or bromine,
Y is $-CX_3$, $-NH_2$, $-NHR^4$, $-NP^4{}_2$, or $-OR^4$, wherein $R^4$ is an alkyl group of 1 to 4 carbon atoms or an aryl group containing 6 to 10 carbon atoms, and
$R^5$ is $-CX_3$, an alkyl group of 1 to 12 carbon atoms, an aryl group of 6 to 12 carbon atoms, an alkenyl group of 2 to 12 carbon atoms, or an aralkenyl group containing from 8 to 20 carbon atoms.

8. A photopolymerizable composition as recited in claim 6 wherein said mercaptobenzazoles have the general structure

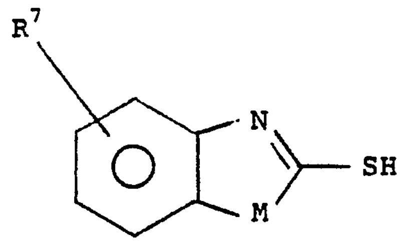

wherein,
$R^7$ is alkyl, alkoxy, hydroxy, or a halogen, and
M is oxygen, sulfur, or $=NR^8$ where $R^8$ is H or lower alkyl.